# EUROPEAN PATENT SPECIFICATION

(11) **EP 2 978 551 B1**
(45) Date of publication and mention of the grant of the patent: **05.04.2017**
(21) Application number: 14728632.2
(22) Date of filing: 28.03.2014
(51) Int. Cl.: B22F 3/105, B22F 3/087, B28B 11/24

(54) **A DEVICE AND A METHOD FOR CONSOLIDATION OF POWDER MATERIALS**
VORRICHTUNG UND VERFAHREN ZUR KONSOLIDIERUNG VON PULVERFÖRMIGEN STOFFEN
DISPOSITIF ET PROCÉDÉ POUR CONSOLIDATION DE MATÉRIAUX EN POUDRE

(30) Priority: 28.03.2013 PL 40334413
(43) Date of publication of application: 03.02.2016
(73) Proprietor: GENICORE SPOLKA Z OGRANICZONA ODPOWIEDZIALNOSCIA, 05-510 Konstancin-Jeziorna (PL)
(72) Inventor: ROSINSKI, Marcin, 03-147 Warszawa (PL)
(74) Representative: Bury, Marek
(86) International application number: PCT/IB2014/060261
(87) International publication number: WO 2014/155352

(56) References cited:
- WO-A2-2010/070623
- US-A- 3 508 029
- US-A- 3 670 137
- US-A- 5 084 088

## Description

Present invention relates to a device for sintering of a broad group of nanocrystalline, sub-micron and micron powders, and in particular for production of composite materials with inclusions of particles such as: diamond, cubic boron nitride, Al₂O₃, SiC, Si₃N₄, WC, Ta, ZrO₂, TiC, TiN and the like, together or separately, in matrix of hard material, such as: sintered carbides or high thermal conductivity materials, such as tungsten, molybdenum, aluminium, copper, together or separately.

The process of sintering, manifested by transition of a porous set of powder particles into a solid material, is related to transport of mass in the porous set of particles. One of technologies of material production is powder metallurgy, in which, generally, powder compaction employs: free sintering, hot pressing or hot isostatic pressing.

Sintering by conventional methods often leads to grain growth, and in consequence, to loss of properties resulting from the grain growth in the consolidated material. It happens particularly in the case of consolidation of materials with sub- and nanocrystalline grain size. Particularly significant grain growth during sintering nanocrystalline materials is observed after reaching critical density amounting 90% of the solid material's value. In result, it is difficult to obtain simultaneously a material with grain size below 100 nm and density close to theoretical by conventional sintering methods.

In the last 10-20 years a significant development of electric field activated sintering methods has occurred. These methods allow to conduct the sintering process in a very short time, from a few to over a dozen of minutes, limiting this way grain growth in the consolidated material. In the literature they are referred to as: Electro Discharge Compaction (EDC).

Such a method and corresponding device are disclosed in patent US3670137, which discloses a device for powder materials consolidation, provided with an operating chamber, press connected to the top electrode and the bottom electrode with the consolidated powder accommodated in a suitable mold situated between the electrodes, wherein to the top and bottom electrode there is connected a capacitive circuit with a power supply unit closed by a direct-current switch.

Generally, these methods fall into methods with activation by electric field. In these techniques, similarly like in conventional hot pressing (HIP), the sintering process is realized with uni-axial pressure. A significant disadvantage of hot pressing is high temperature, long process time and small efficiency of heating of the consolidated powder. Moreover, high temperature and long consolidation process time are disadvantageous for obtaining materials with nanocrystalline microstructure. Electric field activated methods also vary in method of thermal energy transfer to the sintered material.

In conventional sintering, thermal energy is delivered through radiation and heat conduction, causing heating of the sintered material from the top of the sinter to its core. This heating method results in small speed and efficiency of heating.

In electric field activated sintering methods, like EDC, thermal energy is discharged directly in the whole volume of the sintered material. This heating method results in high energy efficiency of these methods, because of small losses of energy into the environment. Although heating of the die by current pulses is not different from direct current heating in conventional methods, heating of powder is much more complex. This is caused by many possible paths of current flow through the consolidated powder. In these methods the occur many phenomena activating the sintering process. Spark discharges remove the layer of oxides and adsorbed gasses from the surface of particles and form new contacts and necks by arc discharges. Locally, due to Joule heat generation, contacts and necks are formed, improving further compaction in the sintering process.

In EDC type the source of the energy is a capacitor or a capacitor battery rated for voltage of few thousand to tens of thousand volts. This solution has been disclosed e.g. in international patent applications US Patents No. 4,929,415; 5,084,088; in which, as shown, a capacitor battery having capacitance of 240 µF has been used and the voltage of operation was between 3 and 30 kV. According to the disclosure and state of the art in the field of EDC type sintering methods, application of high voltage of the order of a few thousand volts is critical especially in the initial phase of the sintering process and is related to phenomena of spark discharges between grains of the powder being sintered. By charging and discharging of electric energy high-temperature spark or plasma discharges appear between powder particles. Pulse plasma activates the surface of the sintered particles, removes the oxide layer. In electric field activated sintering removal of oxides and later inter-particle connection occur due to miscellaneous phenomena of resistive heating from thermal and electrical breakdown of the isolating film to arc discharges. The arising difference of potentials between two particles becomes high enough for spark generation and releasing ionization process. Plasma generated between particles serves for activation of their surface by oxide and other impurity removal.

Advantages of EDC method include:
- low temperature of sintering process,
- shorter sintering process time,
- speed of heating unattainable for other sintering techniques,
- high thermal efficiency, which is defined by heating method, electric current is directly applied to the sample and electrically conductive die,
- possibility of sintering powder materials impossible to produce by classic methods.

EDC process uses oscillatory discharging of the capacitor battery for generation of current surges with first half-wave amplitude on the order of tens of kA and total discharge time ca. 1 ms. Operation cycle includes charging the capacitor battery to a given voltage value (from a few to tens of kV), and then oscillatory pulse discharge in the load circuit. EDC process is used to consolidate powder materials (Orrú R, Licheri R, Locci A M, Cincotti A and Cao G 2009 Mater. Sci. Eng. R 63 127), where the energy source is a high value capacitor, with capacitance of hundreds of microfarads. EDC is based on high-voltage discharge (to 30 kV), high pulse current density delivered directly from the capacitor battery with external pressure to the material being sintered, due to which a rapid increase of temperature and very quick sintering process are obtained. In these methods the energy stored in the capacitor battery is delivered to the sintered powder placed in the die and subjected to a simultaneous process of pressing. The cycle of charging the capacitor battery and subsequent discharging repeats with frequency limited on one hand by the power of supply unit charging the battery, and on the other hand by parameters of the spark gap closing the discharging circuit of the capacitor or capacitor battery. So far, in processes using pulsed electric discharging the impulses are initiated by triggering system comprising a triggering module and an air gap switch closing the electric circuit. The triggering module causes electric arcing between the initiating electrode and the receiving electrode. The presence of arcing enables the proper discharge between the main electrodes, which, because of current intensity of tens of thousands amperes, leads to a quick wearing-out of operational surfaces of both electrodes. This process is particularly intensive on edges of the electrodes, because of very high current densities. This results is accelerated wearing-out of the electrodes, and thereby significant decrease of durability of discharging circuitry comprising spark gaps. Their maximum frequency of operation is also limited, caused by presence of ionized air after each discharge. A subsequent discharge can occur only after removal of the ionized air from the space between the electrodes, what, depending on the spark gap's construction and operating voltage, takes at least 0.3 s. This time significantly limits the frequency of operation of spark gaps.

A problem restricting commercial use of EDC type sintering methods is the dependence of spark gap breakdown voltage on environmental conditions, especially air humidity. With the increase of humidity the breakdown voltage decreases, an this in consequence results in loss of technological process repeatability and reflects in the quality of the manufactured product. This problem can be solved by placing the installation in an air-conditioned room with automatic humidity level stabilization. This causes increased production cost and is troublesome in industrial conditions.

Spark gaps pose also a problem with reaching proper speed and precision of control of technological process parameters. This relates e.g. to the necessity of change from a large value current surge to low value with simultaneous increase of frequency of these surges. In circuits of oscillatory capacitor battery discharging such change is achieved by modification of its charging voltage. For a discharge to occur between spark gap's electrodes it is necessary to modify the distance between them, and this requires a break in the technological process.

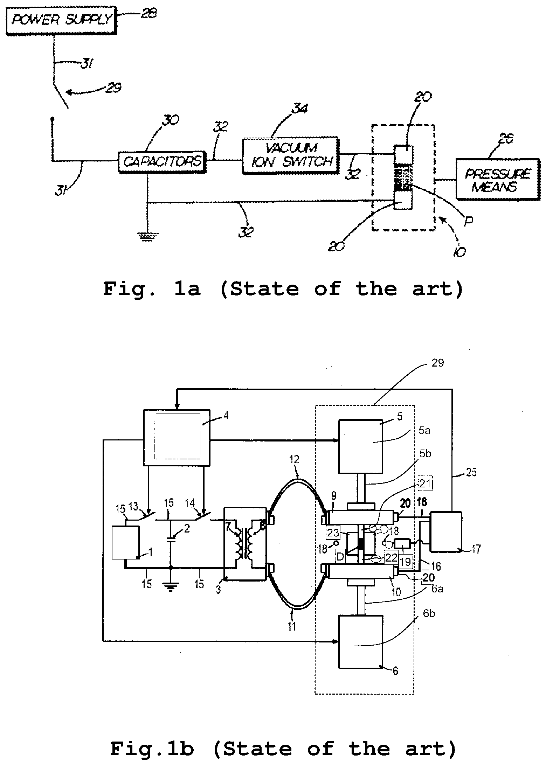

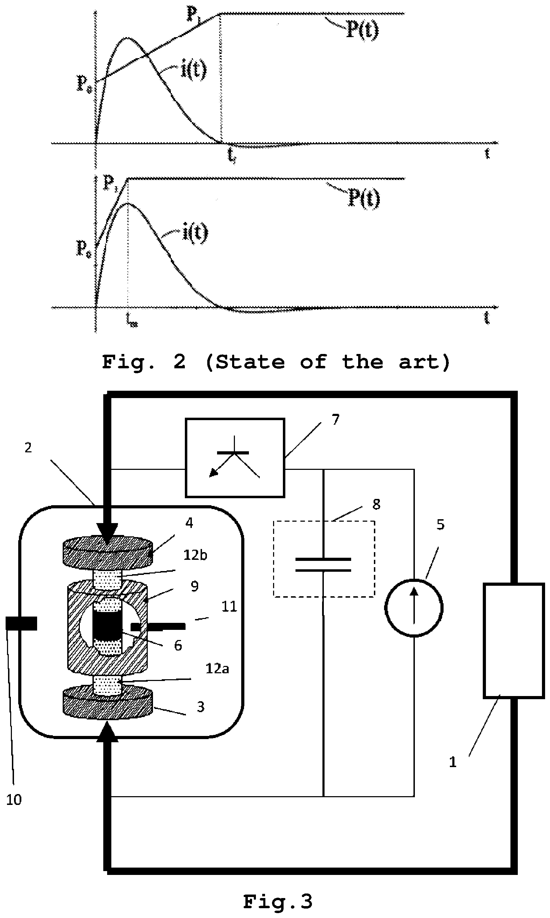

Despite disclosing more than 20 years ago in document US 5084088 a device shown in Fig. 1a and numerous advantages of the EDC method, so far consolidation methods using energy stored in a capacitor battery are not used on an industrial scale. The problem of low durability of devices has been partly solved by application of the device disclosed in international patent application WO 2010/070623. In this device there is used a capacitor battery charged by a power supply and discharged through the sample being heated. Quick wearing-out of the electrodes, usually made of tungsten, molybdenum or copper, makes it impossible to fully utilize the advantages of EDC methods. The solution proposed in document WO 2010/070623 was to use a voltage transformer - Fig. 1b, connected between the switch shorting the capacitor battery, and the sintered sample. The use of voltage transformer allows to provide a longer operation without failure, but simultaneously increases current pulse duration and decreases its maximal value - a current pulse from the state of the art is shown in Fig. 2; tf value is ca. 30 ms - thus making it impossible to utilize the advantages of EDC process idea.

The object of the present invention is to provide a sintering device allowing a precise and quick control of temperature during sintering process, adapted to feed to the sample high and narrow current pulses, repeated with high frequency, with simultaneous provision of a long operation without failure, and a method of powder material sintering, and, in case of diamond based materials, without graphitizing them.

Reaching the object of the invention is provided by sintering device equipped with operational chamber, press connected to top electrode and bottom electrode, between which in the die the consolidated powder is accommodated, onto which the press exerts pressure. Wherein, to the top electrode and to the bottom electrode there is connected a capacitive circuit with a power supply, closed by a high-current switch, wherein the high-current switch is a transistor switch.

Preferably, the transistor switch comprises eight transistors connected in parallel.

Preferably, the transistor switch is adapted to form rectangular pulses, and most preferably, it is adapted to delivering energy to the set being sintered in the form of short pulses with the same and high amplitude, and delivering the same energy in cyclic oscillatory fading waveform of capacitor battery discharging depending on the control signal waveform.

Each transistor in the transistor switch is preferably connected to individual control circuit comprising an adjusted turn-on delay path and an adjusted turn-off delay path.

Preferably the sintering device is further provided with temperature measuring means.

Preferably the temperature measuring means comprise a thermocouple.

Preferably the temperature measuring means comprise a pyrometer.

Preferably the temperature measuring means comprise a thermal imaging camera.

Preferably the electrodes are galvanically isolated from the operational chamber.

Preferably the device is provided with means for cooling the electrodes with a cooling medium.

Preferably the device is provided with sintering process imaging means.

Preferably the capacitive circuit is a capacitor battery with equivalent capacitance in the range of 50-1000 µF and maximal operating voltage of 15 kV.

The object of the invention is also reached by providing a method of powder materials consolidation, wherein the consolidated powder is placed in a die between two electrodes connected to the press exerting pressure onto the powder being consolidated by means of punches. Wherein, a voltage is applied to the electrodes using a capacitive circuit with a power supply, closed by a transistor switch. The powder material is subjected to simultaneous operation of pressing pressure in the range of 1 to 200 MPa and process of sintering by high-current electric pulses with intensity in the range of 1 to 80 kA, repeated with frequency in the range of 0.1 Hz to 100 Hz, depending on the capacitor battery charging voltage, caused by opening the transistor switch. Preferably, electric current pulses are obtained by discharging the battery of capacitors in a capacitive circuit, charged to the voltage of 0.5-15 kV.

Preferably the transistor switch is fed with a control signal disconnecting the capacitor battery discharging circuit during the discharge, most preferably so that a rectangular pulse of capacitor battery discharging current is achieved.

Preferably the powder material is previously subjected to operation of pressing load in the range of 1-200 MPa, at atmospheric pressure or at lowered pressure (1•10⁻⁸ Pa), in a neutral gas or other working gas, before subjecting to operation of electric current pulses.

Preferably the consolidation is done in temperature from the range of 0.5 to 0.8 of melting temperature of consolidated material or melting temperature of consolidated material matrix.

Preferably as the powder material are used powder materials being metallic, ceramic, intermetallic, composites comprising a metallic matrix and dispersed non-metallic particles and mixtures of them.

Preferably as the powder material is used: diamond, cubic boron nitride, Al₂O₃, SiC, Si₃N₄, WC, Ta, ZrO₂, TiC, TiN, together or separately, in a matrix of hard material such as: sintered carbides or high thermal conductivity materials, such as: tungsten, molybdenum, aluminium, copper, together or separately.

Replacement of spark gaps by a transistor switch brings the following advantages:
- radical improvement of switch durability,
- repeatability of current surges,
- higher switch operation frequency (unobtainable for vacuum and air gap switches),
- lower maintenance cost (no replacements of worn-out electrodes).

An advantage of the sintering device according to the invention is the possibility of providing a unique set of sintering parameters, in particular combination of any adjusted shape and intensity within the range of 1-80 kA of the discharging current with the possibility of discharging repetition with frequency up to 100 Hz.

An advantage of the sintering device according to the invention is the possibility of turning off the transistor switch at any time (with no need of oscillatory battery discharging). This solution allows to form rectangular pulses with duration of hundreds of microseconds and adjusted intensity already from a few kA. The possibility of current pulse forming is not achievable with the use of other known semiconductor switches or mechanical switches.

An advantage of the sintering device according to the invention is the possibility of cyclic delivering of energy to the set being sintered, either:
- in form of short pulses with the same high amplitude or
- delivering the same energy, but in form of cyclic oscillatory fading waveform of capacitor battery discharging i.e. underdamped waveform.

The object of the invention is shown in embodiments in the drawings, wherein Fig. 1a is a block diagram of the sintering device with a capacitor battery. Fig. 1b is a block diagram of a modified device. Fig. 2 is a plot showing the current pulse waveform in a state-of-the-art device. Fig. 3 is a block diagram of the drive according to the invention. Fig. 4 shows in tabular form parameters of the device according to the invention, while Fig. 5 is a graph showing current pulse waveform in the device according to the invention.

Fig. 3 is a block diagram of the powder sintering device. The sintering cycle is as follows: the power supply charges capacitors, which are subsequently discharged through the sintered powder placed in a graphite die between two punches connected to the capacitor battery. For controlled capacitor battery discharging a transistor switch is used. The sintering process requires a defined number of capacitor discharging cycles, with specified frequency and their charging voltage. Intensity of current flowing through the powder being sintered during discharging of capacitors achieves the value of a few to tens of kA, and its duration is of hundreds of microseconds. A very short current pulse duration with respect to separation of subsequent pulses from a fraction of a second up to a few seconds creates specific conditions of heating and cooling the sintered powder. During the current flow the powder being sintered is heated to a high temperature, and after it ceases it is cooled very quickly to defined sintering temperature. Duration of capacitor battery discharging current pulse is defined and results directly from parameters of the equivalent circuit of the system. The possibility of reduction of separation of pulses with respect to pulse duration depends on frequency at which the switch can be turned on and off.

The device according to the invention is provided with a hydraulic press 1 exerting pressure in the sintering process and in the process of cooling the sintered powder, wherein between the punches of the press the sintered powder 6 is placed. The sample 6 is between the top electrode 4 and the bottom electrode 3 inside the graphite die 9. The graphite die 9, punches 12a, 12b and the sintered powder 6 are closed in the operating chamber 2, providing a possibility of conducting the sintering process at atmospheric pressure or at lowered pressure (1•10⁻⁸ Pa), in a neutral gas or other working gas continuously supplied to the chamber. Conducting the sintering processes at atmospheric pressure allows to obtain nanocrystalline sinters with pure grain boundaries without a layer of oxides or adsorbed gasses from powders with nanocrystalline size. Conducting the sintering processes in a working gas, e.g. in hydrogen, allows to obtain a strongly reducing atmosphere.

The sintering chamber is made of low-magnetic stainless steel and is opened from one side. In the side part and in the rear part working gas inlets and connections to a vacuum system are located. Gas dosage means are not shown in the drawings. The vacuum pump system, not shown, comprises vacuum pomps adapted to operation in industrial conditions, resistant to sudden drops of high vacuum. The vacuum chamber with vacuum tightness of at least 10⁻⁸ Pa. Electrodes 3, 4 pressing the sintered powder place in the graphite die are simultaneously high-current discharge electrodes, electrically isolated from the processing chamber, and moveable vacuum passages. Electrodes 3, 4 are cooled by a cooling medium and are isolated from the chamber 2 cooled by a cooling medium. The cooling medium is typically water or transformer oil. Electrodes 3, 4 are connected to the capacitor battery 8. Cooling the electrodes 3, 4 protects the vacuum sealing against the impact of high temperature. During sintering a pressure is imposed upon the punches 12a, 12b via the electrodes 3, 4 by means of a hydraulic press 1.

The bottom electrode 3 is movable in order to coarsely define the initial height of the set being sintered (mechanical travel). During the sintering process a pressure is obtained by travelling of the top electrode 4 (hydraulic travel). On the electrodes there are located pads, usually made of steel, mounted by means of bolts (not shown in Fig. 3). This enables replacing them quickly. Electrodes 3, 4 are electrically isolated from the grounded operating chamber 2 by a set of ceramic-teflon sealings (not shown in Fig. 3).

The electrodes bottom 3 and top 4 are connected to the power supply system comprising: capacitive circuit 8 with capacitor battery, and transistor switch 7 closing the capacitive circuit through the sample being sintered. In parallel to the capacitor battery a high-voltage power supply unit 5 is connected.

The high-voltage power supply unit 5 provides an output of suitable current and voltage value for charging the capacitor battery. The high-voltage power supply unit 5 operates as an impulse high-voltage supply unit with current limit. The power supply unit 5 is equipped with a capacitor battery voltage measurement system, allowing their synchronous charging and discharging, and a number of protections including protection against short-circuit in internal circuit of power supply unit, a detector of temperature of inner heat sink with power components, protection against short-circuiting the power supply unit's output. A failure is signalled on a display of the device, which also serves for setting the power supply unit's operation parameters. These parameters can be set by means of a PLC program module.

The capacitive circuit 8 is a capacitor battery with equivalent capacitance within the range of 50-1000 µF, preferably equal to 250 µF, and maximal operating voltage 15 kV. It comprises low-inductance capacitors in series-parallel connection, each adapted to operation with current intensity of tens of kA and steep rise slopes of a dozen or so kA/µs.

Electric pulse discharges applied to the sample 6 are initiated by the transistor switch 7 closing the electric circuit. The transistor switch 7 is built of eight transistors connected in parallel. The transistors are arranged in a multilayer structure providing a uniform pressure of the compressive force. Transistor switches usually are not used for switching so high currents and voltages like in the capacitive circuit according to the invention. It is caused mainly by a relatively low maximal current single transistor. Thus, construction of a transistor switch adapted to operate with voltage at the level of 15 kV and currents of tens of kiloamperes requires the use of a multiple transistor series-parallel circuit and construction of a dedicated control system. In result, the transistor switch has a slightly lower efficiency than alternative solutions available on the market. However, the inventor has observed, that using rectangular pulses instead of oscillatory discharging the capacitor battery a better control over the sintering process is possible, due to a more precise setting of time, duration and the energy transferred to the sintered sample by current flow. Thus, paradoxically, a solution with lower efficiency and more complicated construction has proven advantageous.
Taken into account in the construction of the transistor switch 7 are:
- selection of IGBT transistors, due to forward voltage characteristics in function of conducted current,
- mounting the transistors on a common liquid cooled heat sink (the heat sink in the form of a rectangular cuboid and the transistors mounted on both its greater sides. This construction allows serial connection of switch modules.
- each transistor has a dedicated surge suppression circuit (liquid cooled diode and resistor) and a diode "clamping" the inductance of the load,
- control signal transmitted from the control system to transistor control circuits by means of optical fibre links,
- transmit diodes of the link connected in series and controlled by one transistor,
- power supply of control circuits by means of a power converter (primary winding in the form of a HV conductor loop passing through secondary winding wound on ferrite toroidal cores,
- current leads of all transistors and diodes "clamping" the inductance of the load connected by liquid cooled Cu rails,
- between optical fibre links and control circuits of respective transistors, so-called "drivers", electronic circuits allowing individual adjustment of transistor turn-on delay and adjusted delay of its turn-off are connected. This solution protects against transistor damage during turning off the load current (the slowest transistor turns off the whole current). Delays are set so that voltage waveforms on transistors during turn-on and turn-off mutually "overlapped".

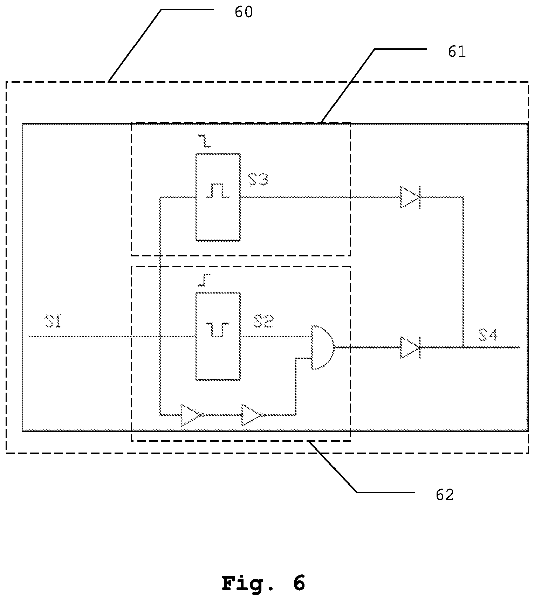

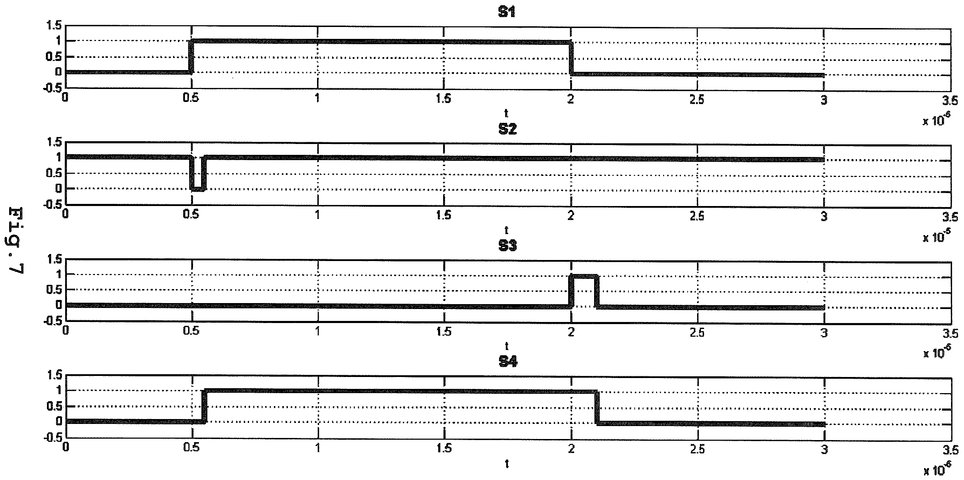

A block diagram of such circuit is presented in Fig. 6. The circuit is provided with an adjusted turn-on delay path 61 and an adjusted turn-off delay path 62. The adjusted turn-on delay path 61 responds to rising edge of signal S1 common for all transistors in the switch. In response to this rising edge generates a short negative pulse in signal S2. Signals S1 and S2 are fed to an AND gate, the output of which is fed through a diode to a transistor (not shown in Fig. 6) in the form of S4 signal. The output signal of AND gate is 0 when value of signal S2 equals 0. Because signal S2 is triggered by a rising edge of signal S1, it is synchronized to its beginning. Thus connecting these signals to an AND gate results in a signal with rising edge delayed with respect to rising edge of signal S1 by the duration of the negative pulse in signal S2. The adjusted turn-off delay path comprises a circuit responsive to falling edge of the signal S1. This circuit generates in its output section S3 a positive pulse, which added through a diode to the signal from the other path causes delay of the falling edge in signal S4 with respect to falling edge in the signal S1 by duration of the positive pulse in signal S3. Such configuration provides the possibility of individual transistor turn-on and turn-off delay. This possibility is used to compensate the production spread of their time of response to control signal. Exemplary waveforms of signals S1, S2, S3, S4 are shown in Fig. 7.

Transistor switch comprising a serial connection of eight transistors rated for maximal pulse current of 5 kA can operate turning on and off current with maximal intensity of 32 kA.

Transistor switch 7 is located directly by the rack of the capacitive circuit in the form of a capacitor battery 8 to minimize lead inductance, where a significant energy is accumulated during discharging pulse rise, with rising speed achieving a few thousand amperes per microsecond.

Mounting the transistors on a common liquid cooled heat sink is preferable (heat sink in the form of rectangular cuboid and transistors mounted on both its greater sides, this construction allows serial connection of switch modules).

The sintering device according to the invention is provided with systems measuring: pressing force, pressure, temperature, size changes of electrodes/punches/consolidated power set-up (measurement of shrinkage and expansion), and monitoring current pulse waveform using a Rogowski coil and oscilloscope, and monitoring the sintering process by application of a CCD camera. Measurement of temperature is implemented in two ways: using a thermoelement 11 located directly in graphite die 9, and/or using a pyrometer 10 on the surface of the graphite die 9 in which the sintering process is conducted. All process parameters, including temperature, pressure, pressing force, current waveform and the progress of the sintering process are recorded in real time and presented in graphic form during the sintering process.

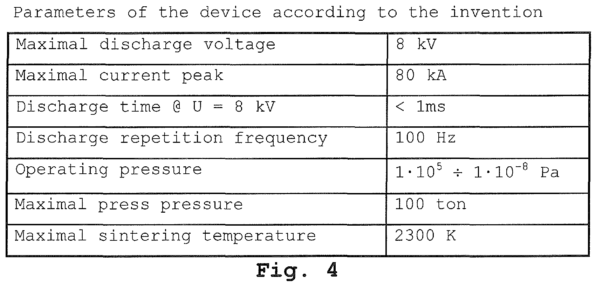

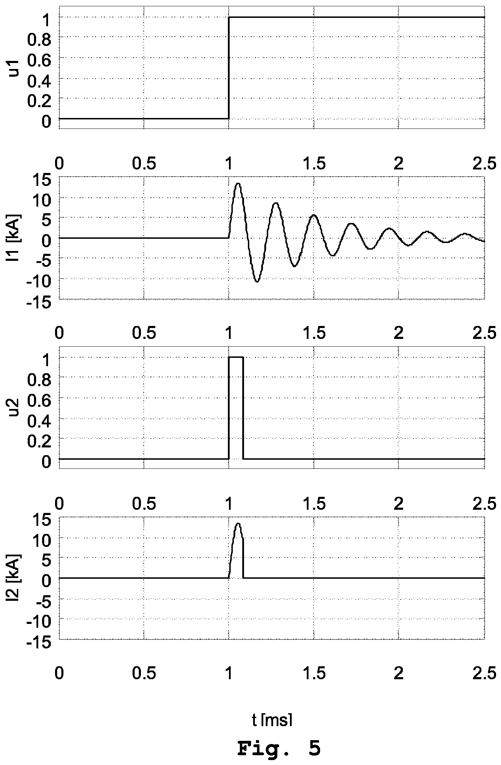

Waveform of discharging pulse induced by closing and opening the transistor switch in the device according to the invention is shown in Fig. 5 in two embodiments. In the first one, the switch is opened and closed by the control waveform U1, shown in Fig. 5 as a binary logic waveform. The switch is open for the whole duration of the oscillatory fading capacitor battery discharging pulse. The sample is heated by current with waveform I1. In the second embodiment the switch is controlled by logic waveform U2. The capacitor battery discharging circuit is disconnected after the first positive half of discharging pulse oscillation. Then, the sintered sample is heated by current I2 with waveform close to rectangular. Also all parameters related to operating conditions of the device are continuously modified from the position of computer control panel. The parameters of the discussed sintering device are collected in the table shown in Fig. 4.

The control system of the device according to the invention comprises a central programmable logic controller (PLC) - Master, collecting data from a few secondary controllers - Slave. Secondary controllers are responsible for monitoring and control of respective subsystems: autonomous high-voltage power supply unit, vacuum system automatics. The central controller (Master) supervises operation of respective slave-type controllers:
- Controller of power supply unit, providing the possibility of monitoring and real-time setting parameters of the power supply unit and is responsible for monitoring of technical condition of construction by application of a monitoring and control system for detection, localization, identification and prediction of development of damage, which can cause malfunction of the power supply unit.
- Vacuum system automatics, which is managed by a distinct PLC controller. The controller is directly responsible for digital control of elements, monitoring of parameters, and also ensuring the safety.
- Supervising subsystem, implemented in a distinct PLC controller. Its task is to monitor local sensors and alarming of emergency situations.

The computer control panel allows to generate:
- timing diagrams, for analysing data correlated in time series,
- event charts, for searching and presentation of data according to criteria other than time, e.g. serial number, number of used setting,
- tabular data, for presentation of data from any source in form of a table, provided with possibility of filtering,
- comments, for adding, storing and sharing explanations of process anomalies or other production events.

The method according to the invention has been presented by the way of examples of application.

For a person skilled in the art it will be apparent, that the presented embodiments of the invention and examples of application of the method according to the invention are only a possible implementation of the invention. With further development of transistor technology it will be possible to replace the system of eight transistors by a smaller number of elements rated for higher voltage and higher operating current, both in IGBT and MOSFET technology.

## Claims

1. Device for powder materials consolidation, provided with operating chamber, press connected to the top electrode and the bottom electrode with accommodated in a die therebetween the consolidated powder to which the press exerts pressure, wherein to the top and bottom electrode there is connected a capacitive circuit with a power supply unit, and with a high-current switch for closing the capacitive circuit through the consolidated powder, **characterized in that** the high-current switch is a transistor switch (7).

2. Device according to the claim 1, **characterized in that** operating chamber (2) is vacuum sealed and is provided with a vacuum system for sintering in lowered ambient pressure, and the electrodes (3) and (4) are isolated from the operating chamber (2).

3. Device according to the claim 1 or 2, **characterized in that** operating chamber (2) is vacuum sealed and is further provided with gas dosage means for sintering in working gas.

4. Device for powder consolidation according to claim 1 or 2 or 3, **characterized in that** the transistor switch (7) comprises eight transistors connected in parallel.

5. Device for powder consolidation according to any of the claims 1 to 4, **characterized in that** the transistor switch (7) is adapted to forming rectangular pulses.

6. Device for powder consolidation according to claim 5, **characterized in that** the transistor switch (7) is adapted both to supply energy to the sintered set in form of short pulses with the same high amplitude and to supply the same energy in cyclic oscillatory fading waveform of capacitor battery discharge, depending on the control signal waveform.

7. Device according to any of the claim from 1 to 6, **characterized in that** a transistor in the transistor switch (7) is connected to control circuit (60) comprising adjusted turn-on delay path (61) and adjusted turn-off delay path (62).

8. Device according to any of claims 1 to 7, **characterized in that** it is further provided with temperature measuring means (10, 11).

9. Device according to any of claims 1 to 8, **characterized in that** the capacitive circuit is a capacitor battery (6) with equivalent capacitance in the range of 50-1000 µF and maximal operating voltage of 15 kV.

10. Method of powder materials consolidation, wherein the sintered powder is located in a die between two electrodes connected to press exerting pressure thereon, wherein voltage is applied to the electrodes through a capacitive circuit with a power supply unit closed by a high-current switch, **characterized in that** the sintered powder is subjected to simultaneous operation of pressure in the range of 1-200 MPa and consolidation by pulses of electric current with intensity of 1-80 kA, repeated with frequency of 0.1 Hz to 100 Hz, generated by opening and closing a high-current switch, which is a transistor switch (7).

11. Method according to claim 10, **characterized in that** electric current pulses are generated by discharging a battery of capacitors in a capacitive circuit charged to the voltage of 0.5-15 kV.

12. Method according to claim 10 or 11, **characterized in that** the transistor switch is fed with a control signal disconnecting circuit of discharging the capacitor battery during the discharging and **in that** the moment of transistor turn-off is selected so that a rectangular capacitor battery discharging current pulse is obtained.

13. Method according to any of claims 10 to 12, **characterized in that** the consolidation is performed in temperature in the range of 0.5 to 0.8 of the melting temperature of the consolidated material or melting temperature of the consolidated material's matrix.

14. Method according to any of claims 10 to 13, **characterized in that** sintered powder is selected from a group of powder materials being metallic, ceramic, intermetallic and composites comprising a metallic matrix and dispersed non-metallic particles or mixtures of thereof.

15. Method according to claim 14, **characterized in that** powder material is selected from a group including in particular diamond, cubic boron nitride, Al₂O₃, SiC, Sl₃N₄, WC, Ta, ZrO₂, TiC, TiN, and mixtures thereof, in a matrix of hard material selected from group including in particular sintered carbides or high thermal conductivity materials selected from a group including in particular tungsten, molybdenum, aluminium, copper, and mixtures thereof.

## Patentansprüche

1. Vorrichtung zum Verfestigen von Pulverwerkstoffen, die mit einem Arbeitsraum versehen ist, einer Presse, die an der oberen Elektrode und der unteren Elektrode angeschlossen ist, mit dem verfestigten Pulver, das in einer Pressform dazwischen untergebracht ist, auf welches die Presse einen Druck ausübt, wobei an der oberen und unteren Elektrode ein kapazitiver Schaltkreis mit einem Netzgerät angeschlossen ist, und mit einem Hochstromschalter zum Schließen des kapazitiven Schaltkreises durch das verfestigte Pulver hindurch, **dadurch gekennzeichnet, dass** der Hochstromschalter ein Transistorschalter (7) ist.

2. Vorrichtung nach Anspruch 1, **dadurch gekennzeichnet, dass** der Arbeitsraum (2) vakuumdicht und mit einem Vakuumsystem zum Sintern unter einem herabgesetzten Umgebungsdruck versehen ist, und die Elektroden (3) und (4) vom Arbeitsraum (2) getrennt sind.

3. Vorrichtung nach Anspruch 1 oder 2, **dadurch gekennzeichnet, dass** der Arbeitsraum (2) vakuumdicht und darüber hinaus mit Gasdosierungsmitteln zum Sintern mit Arbeitsgas versehen ist.

4. Vorrichtung zur Pulververfestigung nach Anspruch 1 oder 2 oder 3, **dadurch gekennzeichnet, dass** der Transistorschalter (7) acht parallel geschaltete Transistoren umfasst.

5. Vorrichtung zur Pulververfestigung nach irgendeinem der Ansprüche 1 bis 4, **dadurch gekennzeichnet, dass** der Transistorschalter (7) ausgeführt ist, um Rechteckimpulse zu bilden.c

6. Vorrichtung zur Pulververfestigung nach Anspruch 5, **dadurch gekennzeichnet, dass** der Transistorschalter (7) je nach Steuersignal-Wellenform sowohl für die Energiezuführung zur gesinterten Menge in Form von Kurzimpulsen mit derselben hohen Amplitude, als auch für die Zuführung derselben Energie in zyklischer periodisch nachlassender Wellenform der Kondensatorbatterieentladung ausgeführt ist.

7. Vorrichtung nach irgendeinem Anspruch 1 bis 6, **dadurch gekennzeichnet, dass** ein Transistor im Transistorschalter (7) an einen Steuerkreis (60) angeschlossen ist, der einen angepassten Einschaltverzögerungspfad (61) und einen angepassten Ausschaltverzögerungspfad (62) umfasst.

8. Vorrichtung nach irgendeinem der Ansprüche 1 bis 7, **dadurch gekennzeichnet, dass** sie darüber hinaus mit Temperaturmessmitteln (10, 11) versehen ist.

9. Vorrichtung nach irgendeinem der Ansprüche 1 bis 8, **dadurch gekennzeichnet, dass** der kapazitive Schaltkreis eine Kondensatorbatterie (6) mit entsprechender Kapazität im Bereich von 50-1000 µF und einer maximalen Betriebsspannung von 15 kV ist.

10. Verfahren zum Verfestigen von Pulverwerkstoffen, wobei sich das gesinterte Pulver in einer Pressform zwischen zwei Elektroden befindet, die an eine Presse angeschlossen sind, die einen Druck darauf ausübt, wobei die Spannung durch einen kapazitiven Schaltkreis mit einem Netzgerät auf die Elektroden angewendet wird, der durch einen Hochstromschalter geschlossen wird, **dadurch gekennzeichnet, dass** das gesinterte Pulver dem gleichzeitigen Anwenden von Druck im Bereich von 1-200 MPa und Verfestigen durch elektrische Stromimpulse mit einer Intensität von 1-80 kA unterliegt, der in einer Frequenz von 0,1 Hz bis 100 Hz wiederholt wird, und durch das Öffnen und Schließen eines Hochstromschalters erfolgt, der ein Transistorschalter (7) ist.

11. Verfahren nach Anspruch 10, **dadurch gekennzeichnet, dass** die elektrischen Stromimpulse durch Entladen einer Batterie von Kondensatoren in einem kapazitiven Schaltkreis erzeugt werden, die auf eine Spannung von 0,5-15 kV geladen wird.

12. Verfahren nach Anspruch 10 oder 11, **dadurch gekennzeichnet, dass** der Transistorschalter mit einem Steuersignal zum Ausschalten des Schaltkreises zum Entladen des Kondensatorbatterie während der Entladung versorgt wird, und dadurch, dass der Zeitpunkt des Ausschaltens des Transistors ausgewählt wird, sodass man einen rechteckigen Kondensatorbatterie-Entladeimpuls erhält.

13. Verfahren nach irgendeinem der Ansprüche 10 bis 12, **dadurch gekennzeichnet, dass** die Verfestigung bei einer Temperatur im Bereich von 0,5 bis 0,8 der Schmelztemperatur des verfestigten Werkstoffs oder der Schmelztemperatur der verfestigten Werkstoffmatrix durchgeführt wird.

14. Verfahren nach irgendeinem der Ansprüche 10 bis 13, **dadurch gekennzeichnet, dass** das gesinterte Pulver aus einer Gruppe von Pulverwerkstoffen ausgewählt wird, die sich aus metallischen, keramischen, intermetallischen und Verbundstoffen, eine metallische Matrix und dispergierte nicht metallische Partikel oder Mischungen daraus umfassend, zusammensetzt.

15. Verfahren nach Anspruch 14, **dadurch gekennzeichnet, dass** der Pulverwerkstoff aus einer Gruppe ausgewählt wird, die im Speziellen Diamant, kubisches Bornitrid, Al₂O₃, SiC, Si₃N₄, WC, Ta, ZrO₂, TiC, TiN, und Gemische daraus enthält, aus einer Matrix von Hartstoffen, die aus einer Gruppe ausgewählt werden, die im Speziellen gesinterte Hartmetalle oder Werkstoffe mit hoher Wärmeleitfähigkeit enthält, die aus einer Gruppe ausgewählt werden, die im Speziellen Wolfram, Molybdän, Aluminium, Kupfer und Gemische daraus enthält.

## Revendications

1. Dispositif pour la consolidation de matériaux de poudre, doté d'une chambre opérationnelle, relié par pressage à l'électrode supérieure et l'électrode inférieure avec la poudre consolidée logée dans une matrice entre elles, sur laquelle la presse exerce la pression, dans lequel un circuit capacitif avec une unité d'alimentation électrique est relié à l'électrode supérieure et inférieure, et avec un commutateur à courant élevé pour la fermeture du circuit capacitif par la poudre consolidée, **caractérisé en ce que** le commutateur à courant élevé est un commutateur de transistor (7).

2. Dispositif selon la revendication 1, **caractérisé en ce que** la chambre opérationnelle (2) est fermée sous vide et est dotée d'un système de vide pour le frittage dans une pression ambiante abaissée, et les électrodes (3) et (4) sont isolées de la chambre opérationnelle (2).

3. Dispositif selon la revendication 1 ou 2, **caractérisé en ce que** la chambre opérationnelle (2) est fermée sous vide et est en outre dotée de moyens de dosage de gaz pour le frittage dans le gaz de travail.

4. Dispositif pour la consolidation de poudre selon la revendication 1 ou 2 ou 3, **caractérisé en ce que** le commutateur de transistor (7) comprend huit transistors reliés en parallèle.

5. Dispositif pour la consolidation de poudre selon l'une quelconque des revendications 1 à 4, **caractérisé en ce que** le commutateur de transistor (7) est adapté pour former des pulsations rectangulaires.

6. Dispositif pour la consolidation de poudre selon la revendication 5, **caractérisé en ce que** le commutateur de transistor (7) est adapté à la fois pour fournir de l'énergie à l'ensemble fritté sous la forme de pulsations courtes avec la même amplitude élevée et pour fournir la même énergie sous la forme d'onde d'affaiblissement oscillatoire cyclique de décharge de batterie de condensateur selon la forme d'onde de signal de commande.

7. Dispositif selon l'une quelconque de la revendication 1 à 6, **caractérisé en ce qu'**un transistor dans le commutateur de transistor (7) est relié à un circuit de commande (60) comprenant une voie de délai d'activation ajustée (61) et une voie de délai de désactivation ajustée (62).

8. Dispositif selon l'une quelconque des revendications 1 à 7, **caractérisé en ce qu'**il est en outre doté de moyens de mesure de température (10, 11).

9. Dispositif selon l'une quelconque des revendications 1 à 8, **caractérisé en ce que** le circuit capacitif est une batterie de condensateur (6) avec une capacitance équivalente dans l'étendue de 50 à 1 000 µF et une tension opérationnelle maximale de 15 kV.

10. Procédé de consolidation de matériaux de poudre, dans lequel la poudre frittée est située dans une matrice entre deux électrodes reliées pour exercer par pressage la pression dessus, dans lequel la tension est appliquée aux électrodes par un circuit capacitif avec une unité d'alimentation fermée par un commutateur à courant élevé, **caractérisé en ce que** la poudre frittée est soumise à l'opération simultanée de pression dans l'étendue de 1 à 200 MPa et la consolidation par des pulsations de courant électrique avec une intensité de 1 à 80 kA, répétées avec une fréquence de 0,1 à 100 Hz, générée par ouverture et fermeture d'un commutateur à courant élevé qui est un commutateur de transistor (7).

11. Procédé selon la revendication 10, **caractérisé en ce que** des pulsations de courant électrique sont générées par décharge d'une batterie de condensateurs dans un circuit capacitif chargé à la tension de 0,5 à 15 kV.

12. Procédé selon la revendication 10 ou 11, **caractérisé en ce que** le commutateur de transistor est chargé avec un signal de commande déconnectant le circuit de décharge de la batterie de condensateur pendant la décharge et **en ce que** le moment de désactivation de transistor est sélectionné de sorte qu'une pulsation de courant déchargeant la batterie de condensateur rectangulaire soit obtenue.

13. Procédé selon l'une quelconque des revendications 10 à 12, **caractérisé en ce que** la consolidation est réalisée en température dans l'étendue de 0,5 à 0,8 de la température de fusion du matériau consolidé ou la température de fusion de la matrice de matériau consolidé.

14. Procédé selon l'une quelconque des revendications 10 à 13, **caractérisé en ce que** la poudre frittée est sélectionnée dans un groupe de matériaux de poudre qui est métallique, céramique, intermétallique et des composites comprenant une matrice métallique et des particules non métalliques dispersées ou mélanges de ceux-ci.

15. Procédé selon la revendication 14, **caractérisé en ce que** le matériau de poudre est sélectionné dans un groupe incluant en particulier le diamant, le nitrure de bore cubique, l'Al₂O₃, le SiC, le Si₃N₄, le WC, le Ta, le ZrO₂, le TiC, le TiN et des mélanges de ceux-ci, dans une matrice de matériau dur sélectionné dans le groupe incluant en particulier des carbures frittés ou matériaux à conductivité thermique élevée sélectionnés dans un groupe incluant en particulier le tungstène, le molybdène, l'aluminium, le cuivre et des mélanges de ceux-ci.
